(19) Europäisches Patentamt
European Patent Office
Office européen des brevets

(11) **EP 4 254 467 A1**

(12) **EUROPEAN PATENT APPLICATION**

(43) Date of publication:
**04.10.2023 Bulletin 2023/40**

(21) Application number: **23163038.5**

(22) Date of filing: **21.03.2023**

(51) International Patent Classification (IPC):
**H01J 37/153** (2006.01)       **H01J 37/244** (2006.01)
**H01J 37/28** (2006.01)

(52) Cooperative Patent Classification (CPC):
**H01J 37/153; H01J 37/244; H01J 37/28;**
H01J 2237/1532; H01J 2237/1534; H01J 2237/21;
H01J 2237/24455; H01J 2237/2446;
H01J 2237/2449; H01J 2237/24514; H01J 2237/28

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2022 JP 2022053654**

(71) Applicant: **Jeol Ltd.**
**Akishima-shi, Tokyo 196-8558 (JP)**

(72) Inventors:
• **SAWADA, Hidetaka**
**Tokyo, 196-8558 (JP)**
• **KANEKO, Takeshi**
**Tokyo, 196-8558 (JP)**
• **MORISHITA, Shigeyuki**
**Tokyo, 196-8558 (JP)**
• **KOHNO, Yuji**
**Tokyo, 196-8558 (JP)**

(74) Representative: **Boult Wade Tennant LLP**
**Salisbury Square House**
**8 Salisbury Square**
**London EC4Y 8AP (GB)**

(54) **ELECTRON MICROSCOPE AND ABERRATION MEASUREMENT METHOD**

(57)     An electron microscope includes an irradiation optical system that focuses electron beams and scans a specimen with the focused electron beams; a deflector that deflects the electron beams transmitted through the specimen; a detector that detects the electron beams transmitted through the specimen; and a control unit that controls the irradiation optical system and the deflector, the control unit causing the irradiation optical system to scan the specimen with the electron beams so that the electron beams have a plurality of irradiation positions on the specimen, the control unit causing the deflector to repeatedly deflect the electron beams transmitted through each of the irradiation positions, so that a plurality of electron beams which have the same irradiation position and different incident angle ranges with respect to the specimen are caused to sequentially enter the detector.

FIG. 1

EP 4 254 467 A1

**Description**

BACKGROUND OF THE INVENTION

The present invention relates to an electron microscope and an aberration measurement method.

A scanning transmission electron microscope (STEM) is attracting attention as an electron microscope that can implement spatial resolution of which the atomic level is extremely high. In such a scanning transmission electron microscope, reducing aberration is critical, and aberration has to be accurately measured to reduce aberration.

For example, JP-A-2012-22971 discloses an aberration measurement method for a scanning transmission electron microscope which includes a segmented detector. According to the aberration measurement method disclosed in JP-A-2012-22971, a bright-field image and a dark-field image are simultaneously acquired from each of a plurality of detection regions using the segmented detector, and each aberration coefficient is calculated using the bright-field image and the dark-field image acquired simultaneously. In the case of the aberration measurement method disclosed in JP-A-2012-22971, the dark-field image with little deviation is used as the reference of the position, hence the measurement accuracy of the aberration coefficient can be improved.

In the case of the aberration measurement method disclosed in JP-A-2012-22971, however, the segmented detector has to be used, as mentioned above.

SUMMARY OF THE INVENTION

According to a first aspect of the present disclosure, there is provided an electron microscope including:

an irradiation optical system that focuses electron beams and scans a specimen with the focused electron beams;
a deflector that deflects the electron beams transmitted through the specimen;
a detector that detects the electron beams transmitted through the specimen; and
a control unit that controls the irradiation optical system and the deflector,
the control unit causing the irradiation optical system to scan the specimen with the electron beams so that the electron beams have a plurality of irradiation positions on the specimen,
the control unit causing the deflector to repeatedly deflect the electron beams transmitted through each of the irradiation positions, so that a plurality of electron beams which have the same irradiation position and different incident angle ranges with respect to the specimen are caused to sequentially enter the detector.

According to a second aspect of the present disclosure, there is provided an aberration measurement method for an electron microscope, the method comprising:

scanning a specimen with electron beams so that the electron beams have a plurality of irradiation positions on the specimen, and deflecting the electron beams transmitted through each of the irradiation positions, so that a plurality of electron beams which have the same irradiation position and different incident angle ranges with respect to the specimen are caused to sequentially enter the detector; and
calculating aberration based on a plurality of images obtained under different conditions of the incident angle range.

BRIEF DESCRIPTION OF THE DRAWINGS

FIG. 1 is a diagram illustrating a configuration of an electron microscope according to an embodiment of the invention.
FIG. 2 is a diagram illustrating a relationship between a specimen and aberration in a case of obtaining a STEM image.
FIG. 3 is a diagram illustrating a relationship between a STEM image and geometrical aberration in a case of moving a detector.
FIG. 4 is a diagram schematically illustrating a bright-field STEM image formed by an electron beam which passed on an optical axis.
FIG. 5 is a diagram schematically illustrating a bright-field STEM image formed by an electron beam having a predetermined convergence angle $\alpha$.
FIG. 6 is a diagram for describing operations of the electron microscope according to an embodiment of the invention.
FIG. 7 is a diagram for describing operations of the electron microscope according to an embodiment of the invention.
FIG. 8 is a diagram schematically illustrating an aperture and a shadow of a condenser aperture.
FIG. 9 is a diagram for describing a method for generating a plurality of STEM images obtained under different conditions of the incident angle range.

FIG. 10 is a diagram illustrating a configuration of an electron microscope according to Modification 2.
FIG. 11 is a diagram for describing a method for generating a plurality of STEM images obtained under different conditions of the incident angle range.

DETAILED DESCRIPTION OF THE INVENTION

According to an embodiment of the present disclosure, there is provided an electron microscope including:

an irradiation optical system that focuses electron beams and scans a specimen with the focused electron beams;
a deflector that deflects the electron beams transmitted through the specimen;
a detector that detects the electron beams transmitted through the specimen; and
a control unit that controls the irradiation optical system and the deflector,
the control unit causing the irradiation optical system to scan the specimen with the electron beams so that the electron beams have a plurality of irradiation positions on the specimen,
the control unit causing the deflector to repeatedly deflect the electron beams transmitted through each of the irradiation positions, so that a plurality of electron beams which have the same irradiation position and different incident angle ranges with respect to the specimen are caused to sequentially enter the detector.

In such an electron microscope, the control unit causes the deflector to repeatedly deflect the electron beams transmitted through each of the irradiation positions, so that a plurality of electron beams which have the same irradiation position and different incident angle ranges with respect to the specimen are caused to sequentially enter the detector. Therefore in this electron microscope, a plurality of scanning transmission electron microscope images, obtained under different conditions of the incident angle range, can be acquired without using the segmented detector.

According to an embodiment of the present disclosure, there is provided an aberration measurement method for an electron microscope, the method including:

scanning a specimen with electron beams so that the electron beams have a plurality of irradiation positions on the specimen, and deflecting the electron beams transmitted through each of the irradiation positions, so that a plurality of electron beams which have the same irradiation position and different incident angle ranges with respect to the specimen are caused to sequentially enter the detector; and
calculating aberration based on a plurality of images obtained under different conditions of the incident angle range.

In this aberration measurement method, the deflector is caused to deflect the electron beams transmitted through each of the irradiation positions, so that a plurality of electron beams which have the same irradiation position and different incident angle ranges with respect to the specimen are caused to sequentially enter the detector. Therefore in this aberration measurement method, a plurality of scanning transmission electron microscope images, obtained under different conditions of the incident angle range, can be acquired without using the segmented detector.

Preferred embodiments of the invention will now be described in detail with reference to the drawings. It is noted that the following embodiments described below do not unduly limit the scope of the invention as stated in the claims. Further, all of the components described in the following embodiments are not necessarily essential requirements of the invention.

1. Electron microscope

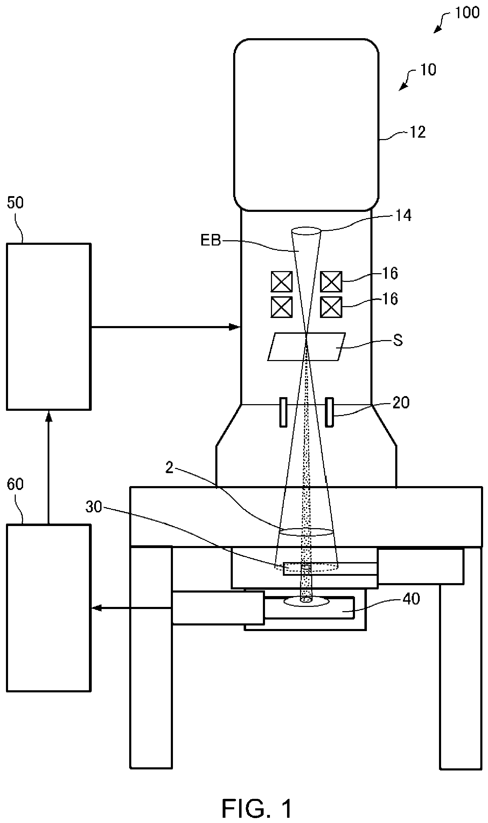

An electron microscope according to an embodiment of the invention will now be described with reference to the drawings. FIG. 1 is a diagram illustrating a configuration of the electron microscope 100 according to an embodiment of the invention.

As illustrated in FIG. 1, the electron microscope 100 includes: an irradiation optical system 10, a deflector 20, an aperture 30, a detector 40, a control unit 50 and an arithmetic unit 60. The electron microscope 100 is a scanning transmission electron microscope that acquires a scanning transmission electron microscope image (STEM image) by scanning a specimen S with an electron beam EB.

The irradiation optical system 10 focuses the electron beam EB, and scans the specimen S with the focused electron beam EB. The irradiation optical system 10 includes: an electron beam source 12, a condenser aperture 14, and a scanning deflector 16. The irradiation optical system 10 further includes: a condenser lens, an objective lens, and an aberration correction device which are not illustrated here.

The electron beam source 12 emits an electron beam EB. The electron beam source 12 is an electron gun, for example, which accelerates an electron emitted from a cathode by an anode, and emits an electron beam EB.

The condenser aperture 14 determines a convergence angle of the electron beam EB emitted from the electron beam source 12. A plurality of aperture holes are formed in the condenser aperture 14, and the convergence angle of the electron beam EB can be adjusted by changing the aperture hole.

The electron beam EB emitted from the electron beam source 12 is focused by the condenser lens and the objective lens. An aberration correction device is integrated into the irradiation optical system 10, so as to correct the aberration of the irradiation optical system 10. In the electron microscope 100, the arithmetic unit 60 measures the aberration, and the control unit 50 controls the aberration correction device based on the aberration measurement result by the arithmetic unit 60.

The scanning deflector 16 two-dimensionally deflects the focused electron beam EB. By deflecting the electron beam EB using the scanning deflector 16, the specimen S can be scanned with the focused electron beam EB.

The specimen S is supported by a specimen stage (not illustrated).

The deflector 20 two-dimensionally deflects the electron beam EB transmitted through the specimen S. The deflector 20 is disposed in a subsequent stage of the specimen S. The deflector 20 is an electrostatic deflector which generates an electrostatic field, and deflects the electron beam EB transmitted through the specimen S thereby. The deflector 20 can deflect the electron beam EB faster compared with a magnetic field coil which generates a magnetic field and deflects the electron beam EB thereby, for example. The deflector 20 can deflect the electron beam EB in a nanosecond order, for example.

The aperture 30 is disposed in the previous stage of the detector 40. Specifically, the aperture 30 is disposed between the deflector 20 and the detector 40. The aperture 30 is a bright-field aperture, for example. By the aperture 30, the electron beam EB in a preferred incident angel range can be extracted from the electron beams EB transmitted through the specimen S. The incident angle range is a range of the incident angle of the electron beam EB with respect to the specimen S.

The electron microscope 100 includes an image forming optical system (not illustrated), and the electron beam EB transmitted through the specimen S is guided to the detector 40 by the image forming optical system.

The detector 40 detects the electron beam EB transmitted through the specimen S. The detector 40 is a bright-field STEM detector, for example. The bright-field STEM detector detects electrons transmitted without being scattered and electrons that scattered at a small angle, out of the electron beams EB transmitted through the specimen S.

The control unit 50 controls each component of the electron microscope 100. For example, the control unit 50 controls the irradiation optical system 10 and the deflector 20. The control unit 50 includes such processors as a central processing unit (CPU) and a digital signal processor (DSP), and such storage devices as a random access memory (RAM) and a ready only memory (ROM). The control unit 50 performs various kinds of calculation processing and control processing, by executing programs stored in the storage devices using the processors.

The arithmetic unit 60 calculates aberration of the irradiation optical system 10. For example, the arithmetic unit 60 includes such processors as a CPU and a DSP, and such storage devices as a RAM and ROM. The arithmetic unit 60 performs various types of calculation processing by executing programs stored in the storage devices using the processors.

2. Aberration measurement method

2.1. Principle

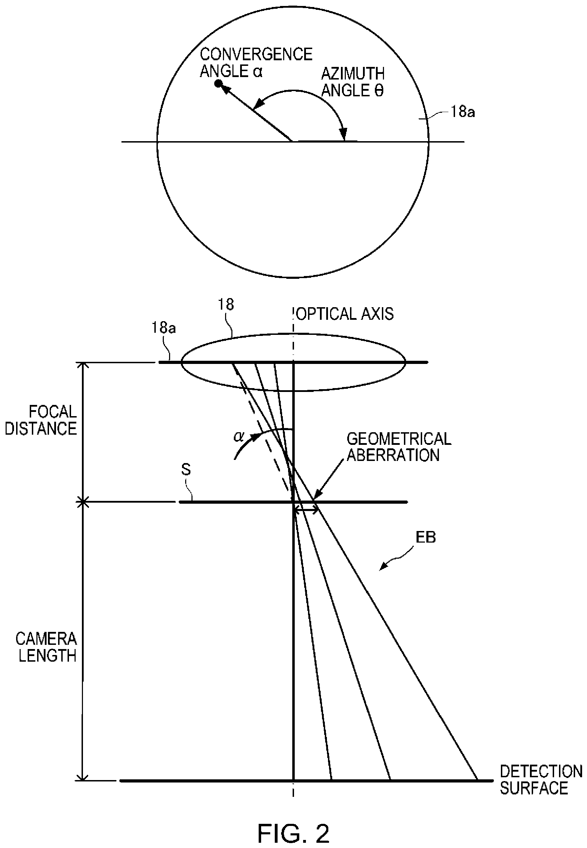

An aberration measurement method will be described next. FIG. 2 is a diagram illustrating a relationship between a specimen S and an aberration when a STEM image is acquired.

The specimen S is disposed at a position that is distant from a front focal plane 18a of an objective lens 18 by a focal distance. A detection surface of the detector 40 is disposed at a position that is distant from the specimen S by a camera length. FIG. 2 illustrates a state where the electron beam EB transmits through the front focal plane 18a of the objective lens 18, and is converged toward the specimen S by the converging function of the objective lens 18.

The convergence angle $\alpha$ is a convergence angle of the electron beam EB with respect to the specimen S, and the azimuth angle $\theta$ is an azimuth angle of the electron beam EB on the specimen S. If there is no geometric aberration, each electron beam concentrates to one point on the specimen S, as shown by the broken line, regardless the convergence angle $\alpha$ and the azimuth angle $\theta$ thereof. However, if there is an aberration (geometric aberration), the location where each electron beam EB reaches on the detection surface of the detector 40 differs depending on the convergence angle $\alpha$.

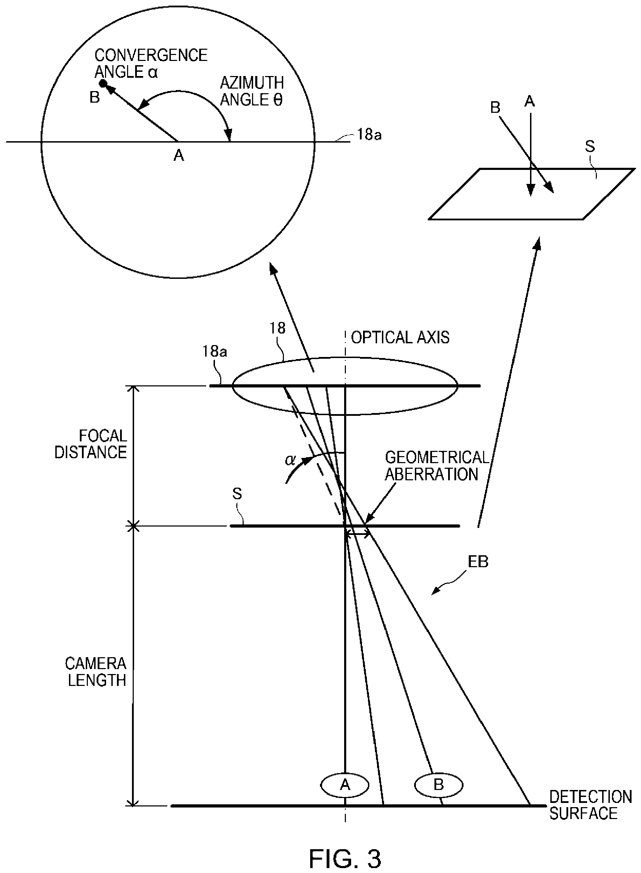

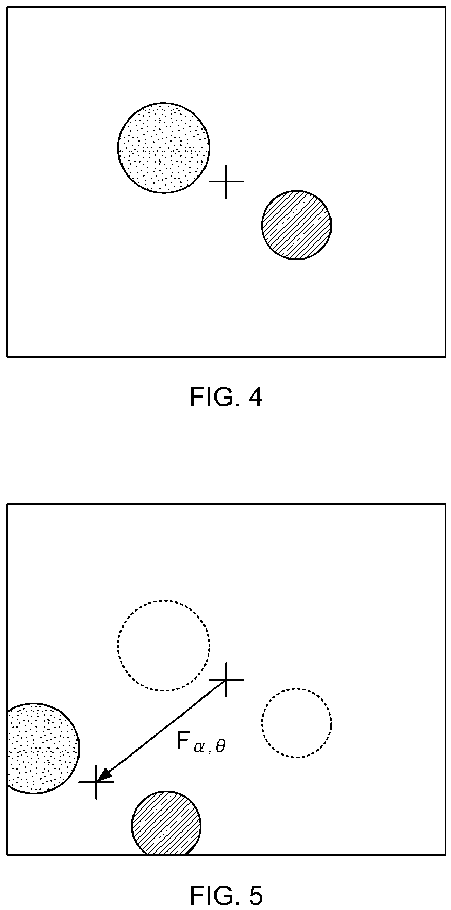

FIG. 3 is a diagram illustrating a relationship between the STEM image and the geometric aberration in a case where the detector 40 is moved from a position A to a position B. FIG. 3 includes a conceptual diagram in an angle space on the front focal plane 18a, and a schematic diagram illustrating changes in the irradiation position of the electron beam EB on the specimen S surface caused by the aberration. FIG. 4 is a diagram schematically illustrating a bright-field STEM image formed by the electron beam EB, which passed on the optical axis, and FIG. 5 is a diagram schematically illustrating a bright-field STEM image formed by the electron beam EB having a predetermined convergence angle $\alpha$.

In the case where there is no geometric aberration, even if the detector 40 is moved from a position A to a position B, the irradiation position with the electron beam EB on the specimen S that the detector 40 detects at a position A and the irradiation position with the electron beam EB on the specimen S that the detector 40 detects at a position B are the same. Therefore a field deviation of the STEM image is not generated, even if the detector 40 is moved from the position A to the position B.

In the case where there is geometric aberration, on the other hand, if the detector 40 is moved from position A to position B, a deviation in accordance with the geometric aberration is generated between the irradiation position with the electron beam EB on the specimen S that the detector 40 detects at the position A, and the irradiation position with the electron beam EB on the specimen S that the detector 40 detects at the position B. Therefore as illustrated in FIG. 4 and FIG. 5, a field deviation is generated in the STEM image if the detector 40 is moved from position A to position B.

If the field deviation generated by moving the detector 40 from position A to position B is assumed to be $P_{\alpha,\theta}$, the vector in the opposite direction is geometric aberration vector $G_{\alpha,\theta}$ at the convergence angle $\alpha$ and azimuth angle $\theta$.

The front focal plane 18a of the objective lens 18 is an angle space plane of the electron beam EB. In other words, as the conceptual diagram in FIG. 2 illustrates, if each position of the electron beam EB on the front focal plane 18a is expressed by polar coordinates, the radical component and the angle component thereof is uniquely expressed respectively using the convergence angle $\alpha$ and the azimuth angle $\theta$. The aberration function x on the front focal plane 18a is given by the total of each wavefront aberration, which is a function of the convergence angle $\alpha$ and the azimuth angle $\theta$. Considering that only an axial aberration is handled in atomic level high resolution observation, the aberration function x ($\alpha$, $\theta$) is generated as follows.

$$x\ (\alpha,\ \theta) = \text{defocus} + 2\ \text{fold astigmatism}$$

$$+ \text{axial coma aberration} + \text{3-fold astigmatism}$$

$$+ \text{spherical aberration} + \text{star aberration} + \text{4-fold astigmatism}$$

$$+ \text{fourth order coma aberration} + \text{three lobe aberration} + \text{5-fold astigmatism}$$

$$+ \text{fifth order spherical aberration} + \text{6-fold astigmatism}$$

In other words, the aberration function x ($\alpha$, $\theta$) is expressed by the following Formula (1).

$$\chi(\alpha,\theta) = \frac{1}{2}\alpha^2 o_2 + \frac{1}{2}\alpha^2 a_2 \cos\big(2(\theta - \theta_{a2})\big)$$
$$+ \frac{1}{2}\alpha^3 p_3 \cos(\theta - \theta_{p3}) + \frac{1}{3}\alpha^3 a_3 \cos\big(3(\theta - \theta_{a3})\big)$$
$$+ \frac{1}{4}\alpha^4 o_4 + \frac{1}{4}\alpha^4 q_4 \cos\big(2(\theta - \theta_{q4})\big) + \frac{1}{4}\alpha^4 a_4 \cos\big(4(\theta - \theta_{a4})\big) \qquad (1)$$
$$+ \frac{1}{5}\alpha^5 p_5 \cos(\theta - \theta_{p5}) + \frac{1}{5}\alpha^5 r_5 \cos\big(3(\theta - \theta_{r5})\big) + \frac{1}{5}\alpha^5 a_5 \cos\big(5(\theta - \theta_{a5})\big)$$
$$+ \frac{1}{6}\alpha^6 o_6 + \frac{1}{6}\alpha^6 a_6 \cos\big(6(\theta - \theta_{a6})\big) + \cdots$$

Each component $G_\alpha$ and $G_\theta$ of the geometrical aberration vector $G_{\alpha,\theta}$ in the convergence angle direction and the azimuth angle direction are determined by partially differentiating the aberration function x with respect to the convergence angle $\alpha$ and the azimuth angle $\theta$ respectively.

$$G_{\alpha,\theta} = (G_\alpha, G_\theta) = \left(\frac{\lambda}{2\pi}\frac{\partial\chi}{\partial\alpha}, \frac{\lambda}{2\pi}\frac{1}{\alpha}\frac{\partial\chi}{\partial\theta}\right) \qquad (2)$$

In other words, by acquiring a bright-field image for each of a plurality of sets of the convergence angle $\alpha$ and the azimuth angle $\theta$, a same number of geometrical aberration vectors $G_{\alpha,\theta}$ as the number of sets can be acquired, and each aberration function can be calculated by performing mathematical processing (e.g. least square method) on these geometrical aberration vectors $G_{\alpha,\theta}$.

2.2 Operation

An operation of the electron microscope 100 will be described next. Here an operation of the electron microscope 100, when an aberration is measured, will be described.

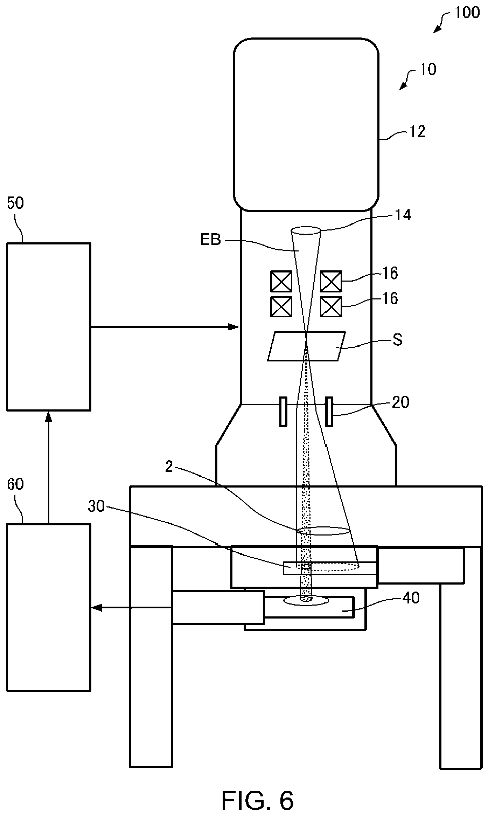

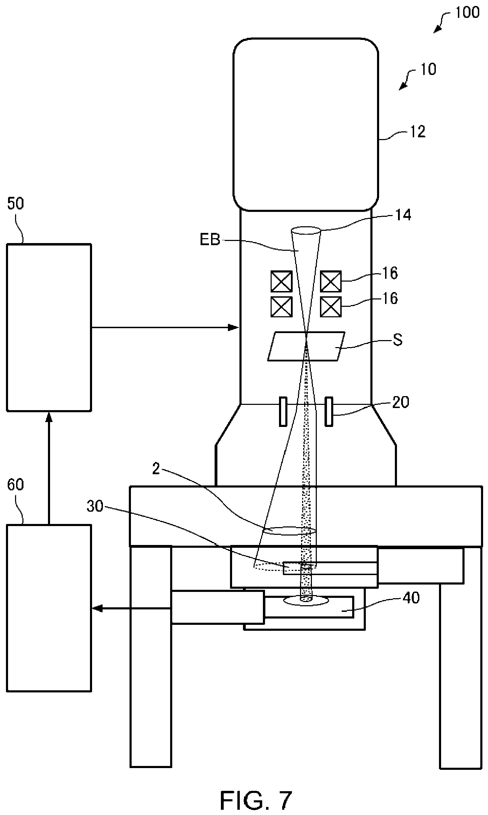

FIG. 6 and FIG. 7 are diagrams for describing operations of the electron microscope 100.

First as illustrated in FIG. 1, the aperture 30 is disposed in front of the detector 40. Then the electron beam EB, emitted from the electron beam source 12 in the irradiation optical system 10, is converged. Here the position of the aperture 30 is adjusted so that the center of the electron beam EB, that passed through the condenser aperture 14, passes through the center of the aperture 30. By the electron beam EB passing through the aperture 30, the ranges of the convergence angle $\alpha$ and the azimuth angle $\theta$ of the electron beam EB to be detected by the detector 40 are limited. In other words, by the electron beam EB passing through the aperture 30, the incident angle range of the electron beam EB to be detected by the detector 40 is limited. The incident angle range is the ranges of the convergence angle $\alpha$ and the azimuth angle $\theta$.

Then the control unit 50 causes the scanning deflector 16 to start scanning with the electron beam EB, and causes the deflector 20 to deflect the electron beam EB for a plurality of times at each irradiation position with the electron beam EB (at each pixel) on the specimen S.

By the deflector 20 deflecting the electron beam EB, electron beams EB, of which incident angle ranges are mutually different, out of the electron beams EB transmitted through the specimen S, can enter the detector 40, as illustrated in FIG. 6 and FIG. 7. By the deflector 20 changing the deflection direction and the deflection amount of the electron beam EB, electron beams EB in different ranges of the convergence angle $\alpha$ and different ranges of the azimuth angle $\theta$ can enter the detector 40.

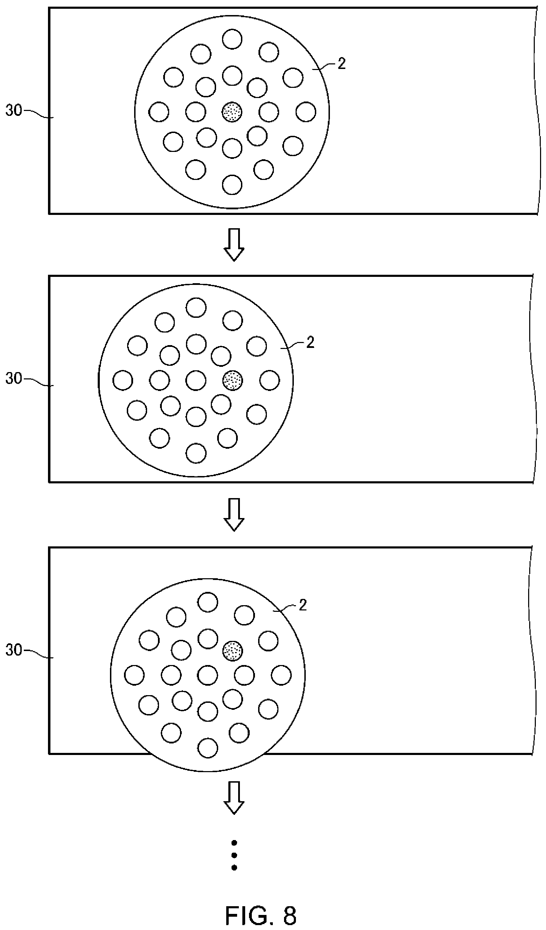

FIG. 8 is a diagram schematically illustrating the aperture 30 and the shadow 2 of the condenser aperture 14. In FIG. 8, electron beams of which incident angel ranges are mutually different are illustrated by circles, and the electron beam EB that passes through the aperture 30 when the electron beam EB is deflected by the deflector 20 is hatched.

By deflecting an electron beam EB using the deflector 20, the shadow 2 of the condenser aperture 14 moves with respect to the aperture 30 which is fixed. Therefore an electron beam EB having a desired incident angle range can be extracted by the aperture 30, by deflecting each electron beam EB using the deflector 20.

In the example illustrated in FIG. 8, an electron beam EB is deflected 20 times at one irradiation position (at one pixel), and 21 electron beams EB of which incident angle ranges are different, are detected. The number of times of deflecting the electron beam EB at one irradiation position may be set according to the type of aberration to be measured, the accuracy of the measurement, and the like.

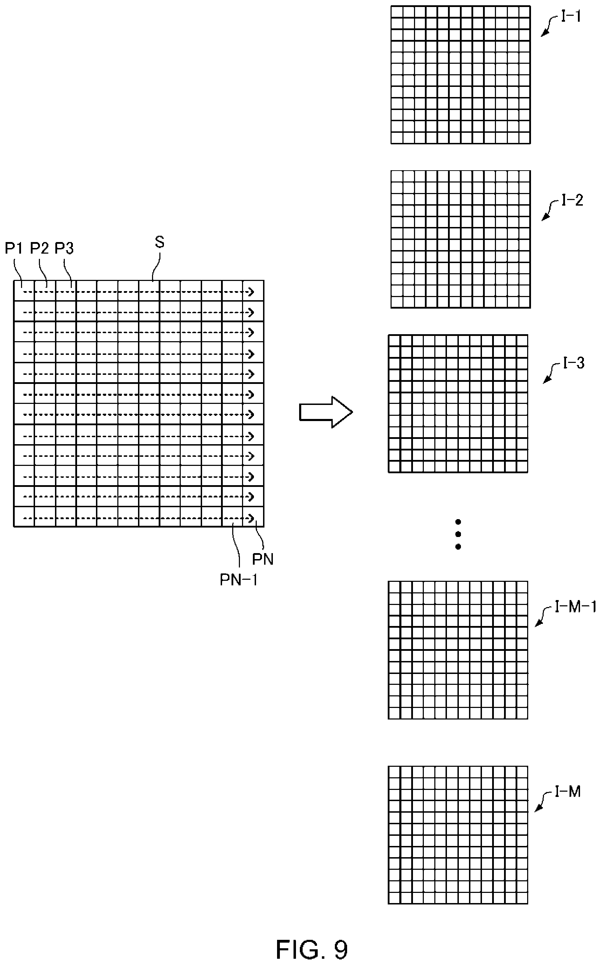

FIG. 9 is a diagram for describing a method for generating STEM images obtained under the different conditions of the incident angle range.

In the electron microscope 100, a specimen S is raster-scanned with an electron beam EB. In the example illustrated in FIG. 9, an irradiation position P1 is irradiated with the electron beam EB first, then the electron beam EB is moved, and the irradiation position P2 is irradiated therewith. These steps are repeated and in the end a irradiation position PN is irradiated, then scanning the specimen S ends. Here at each irradiation position, the electron beam EB is deflected by the deflector 20 in accordance with a number of STEM images to be acquired.

In the example illustrated in FIG. 9, in order to acquire M number of STEM images 1-1 to I-M, the electron beam EB is detected by the detector 40, as illustrated in FIG. 1, at each irradiation position, then each time the electron beam EB is deflected by the deflector 20, as illustrated in FIG. 6 and FIG. 7, the electron beam EB is detected by the detector 40, and this step is repeated for M-1 times.

For example, at the irradiation position P1, the electron beam EB is detected by the detector 40, as illustrated in FIG. 1, then each time the electron beam EB is deflected by the deflector 20, the electron beam EB is detected by the detector 40, and this step is repeated for M-1 times. As a result, the intensity data of the electron beam EB can be acquired for a pixel corresponding to the irradiation position P1 for each of the STEM images 1-1 to I-M.

Then the electron beam EB is moved from the irradiation position P1 to an irradiation position P2, and after the electron beam EB is detected by the detector 40 at the irradiation position P2, the electron beam EB is detected by the detector 40 each time the electron beam EB is deflected by the deflector 20, and this step is repeated for M-1 times. As a result, the intensity data of the electron beam EB can be acquired for a pixel corresponding to the irradiation position P2 for each of the STEM images 1-1 to I-M.

This operation is repeated at each irradiation position, and finally the electron beam EB is moved from a irradiation position PN-1 to an irradiation position PN, and after the electron beam EB is detected by the detector 40 at the irradiation position PN, the electron beam EB is detected by the detector 40 each time the electron beam EB is deflected by the deflector 20, and this step is repeated for M-1 times. As a result, the intensity data of the electron beam EB can be acquired for a pixel corresponding to the irradiation position PN for each of the STEM images 1-1 to I-M.

In this way, M number of STEM images 1-1 to I-M can be acquired.

As described above, in the electron microscope 100, the electron beam EB is deflected at each irradiation position of the electron beam EB while performing scanning with the electron beam EB, whereby electron beams EB, of which incident angle ranges with respect to the specimen S are different, can enter the detector 40 for each irradiation position. Therefore in the electron microscope 100, a plurality of STEM images, obtained under different conditions of the incident angle range, can be acquired in one scan. For example, in the case of the example in FIG. 8, 21 STEM images, obtained under different conditions of the incident angle ranges, can be acquired in one scan.

Using the above mentioned method described in "2.1. Principle", the arithmetic unit 60 calculates the aberration based on the plurality of STEM images obtained under different conditions of the incident angle range. The control unit 50 operates the aberration correction device based on the result of the aberration calculated by the arithmetic unit 60. Thereby the aberration of the irradiation optical system 10 can be corrected.

3. Effect

In the electron microscope 100, the control unit 50 causes the irradiation optical system 10 to scan the specimen S with the electron beam EB, and causes the deflector 20 to deflect the electron beam EB transmitted through the specimen S for each irradiation position with the electron beam EB, so that the electron beams EB, of which incident angle ranges with respect to the specimen S are different, out of the electron beams EB transmitted through the specimen S for each irradiation position with the electron beam EB, enter the detector 40. Therefore, in the electron microscope 100, a plurality of STEM images, obtained under different conditions of the incident angle range, can be acquired.

For example, a conventionally known aberration measurement method is a method of using an nm-order gold fine particle as a standard specimen, calculating a deconvolution calculation probe shape using a Gaussian focus image and an under focus image (or over focus image), and estimating an aberration thereby. By this method, however, the standard specimen must be used. In the case of the electron microscope 100, on the other hand, the aberration can be measured without using the standard specimen.

Another example of a conventionally known aberration measurement method is a method of calculating the aberration from a Ronchigram. A CCD camera or a CMOS camera is required to acquire a Ronchigram.

Still another example of a conventionally known aberration measurement method is a method of measuring the aberration using a segmented detector. In the case of this method, a bright-field image is acquired for each detection region of the segmented detector, and the aberration is calculated based on the field deviation among the bright-field images. In other words, this segmented detector is required.

In the case of the electron microscope 100, on the other hand, the aberration can be measured using the bright-field STEM detector. This means that the electron microscope 100 does not required the CCD camera, the CMOS camera and the segmented detector.

In the electron microscope 100, a plurality of STEM images, to measure the aberration, can be simultaneously acquired by one scan. Therefore the aberration measurement errors caused by a drift of the specimen S can be reduced.

The electron microscope 100 includes the aperture 30, which is disposed between the deflector 20 and the detector 40 and limits the incident angle range of the electron beam EB to be detected by the detector 40. The electron microscope 100 can extract the electron beam EB in a preferred incident angle range using the aperture 30, by deflecting the electron beam EB by the deflector 20. For example, the incident angle range can be changed by changing the diameter of the aperture hole of the aperture 30.

In the electron microscope 100, the deflector 20 is an electrostatic deflector. Therefore the electron beam EB can be deflected faster than the case of using a magnetic field coil as the deflector 20, for example. This means that a plurality of STEM images obtained under different conditions of the incident angle range can be acquired in a short time.

4. Modifications

The invention is not limited to the above embodiments, but may be modified in various ways within the scope of the spirit of the invention.

(1) Modification 1

In the embodiments described above, the bright-field aperture is used as the aperture 30 between the deflector 20 and the detector 40, but an aperture other than the bright-field aperture may be used as the aperture 30, as long as the incident angle range of the electron beam EB to be detected by the detector 40 can be limited.

(2) Modification 2

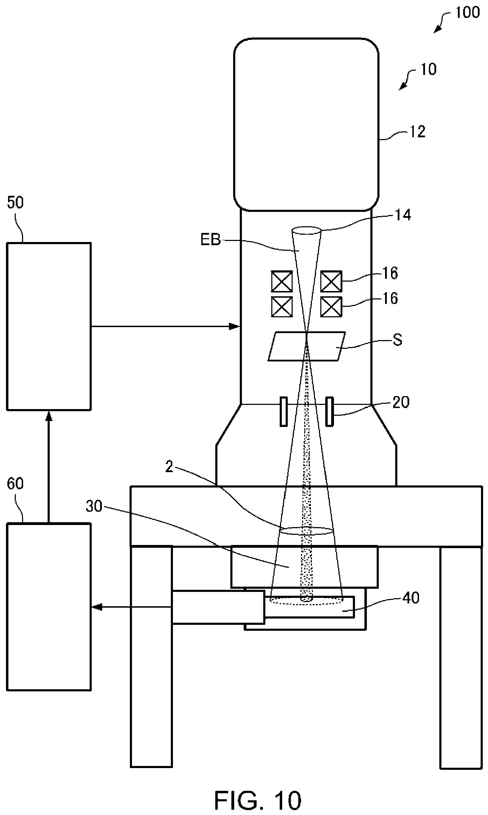

FIG. 10 is a diagram illustrating a configuration of an electron microscope 100 according to Modification 2.
In the embodiments described above, the incident angle range of the electron beam EB to be detected by the detector 40 using the aperture 30 is limited, as illustrated in FIG. 1, but the incident angle range of the electron beam EB to be detected by the detector 40 may be limited by decreasing the detection region of the detector 40 without using the aperture 30, as illustrated in FIG. 10.

(3) Modification 3

In the embodiments described above, the detector 40, that detects the electron beam EB transmitted through the specimen S, is the bright-field STEM detector, but the detector 40 that detects the electron beam EB transmitted through the specimen S may be a dark-field STEM detector that includes an annular-shaped detection region.

(4) Modification 4

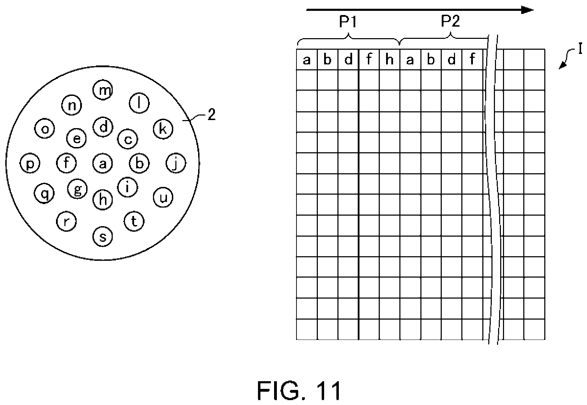

FIG. 11 is a diagram for describing a method for generating a plurality of STEM images obtained under different conditions of the incident angle range. a to u in FIG. 11 indicate incident angle ranges extracted using the aperture 30.
In the case of acquiring a plurality of STEM images obtained under conditions of the incident angle range a, incident angle range b, incident angle range d, incident angle range f and incident angle range h, the arithmetic unit 60 acquires the detection result by the detector 40 first, synchronizing with the scanning with the electron beam EB by the scanning deflector 16 and the deflection of the electron beam EB by the deflector 20. Thereby the STEM image I in FIG. 11 can be acquired. In the STEM image I, detection results obtained under different conditions of the incident angle range are disposed in a time series for each irradiation position.
In the STEM image I, for example, in the irradiation position P1, information on the intensity of the electron beam EB obtained under the condition of the incident angle range a, information on the intensity of the electron beam EB obtained under the condition of the incident angle range b, information on the intensity of the electron beam EB obtained under the condition of the incident angle range d, information on the intensity of the electron beam EB obtained under the condition of the incident angle range f, information on the intensity of the electron beam EB obtained under the condition of the incident angle range h are disposed in this sequence. In the irradiation position P2 next to the irradiation position P1, information on the intensity of the electron beam EB obtained under the condition of the incident angle range a, information on the intensity of the electron beam EB obtained under the condition of the incident angle range b, information on the intensity of the electron beam EB obtained under the condition of the incident angle range d, information on the intensity of the electron beam EB obtained under the condition of the incident angle range f, and information on the intensity of the electron beam EB obtained under the condition of the incident angle range h are disposed in this sequence. In this way, in the STEM image I, information on the intensity of the electron beam EB obtained under each condition of the incident angle range is disposed from the irradiation position P1 to the irradiation position PN.
For each condition of the incident angle range, the arithmetic unit 60 acquires information on the intensity at each irradiation position from the STEM image I, and generates a STEM image obtained under the condition of the incident angle range a, a STEM image obtained under the condition of the incident angle range b, a STEM image obtained under the condition of the incident angle range d, a STEM image obtained under the condition of the incident angle range f, and a STEM image obtained under the condition of the incident angle range h.
In this way, a plurality of STEM images obtained under different conditions of the incident angle range can be generated from one STEM image I.
The invention is not limited to the above-described embodiments, and various modifications can be made. For example, the invention includes configurations that are substantially the same as the configurations described in the embodiments. Substantially same configurations mean configurations having the same functions and methods, for example. The invention also includes configurations obtained by replacing non-essential elements of the configurations described in the embodiments with other elements. The invention further includes configurations obtained by adding known art to the configurations described in the embodiments.

**Claims**

1. An electron microscope comprising:

   an irradiation optical system that focuses electron beams and scans a specimen with the focused electron beams;
   a deflector that deflects the electron beams transmitted through the specimen;

a detector that detects the electron beams transmitted through the specimen; and

a control unit that controls the irradiation optical system and the deflector,

the control unit causing the irradiation optical system to scan the specimen with the electron beams so that the electron beams have a plurality of irradiation positions on the specimen,

the control unit causing the deflector to repeatedly deflect the electron beams transmitted through each of the irradiation positions, so that a plurality of electron beams which have the same irradiation position and different incident angle ranges with respect to the specimen are caused to sequentially enter the detector.

2. The electron microscope according to claim 1, further comprising an aperture that is disposed between the deflector and the detector, and limits the incident angle ranges of electron beams to be detected by the detector.

3. The electron microscope according to claim 1 or 2, further comprising an arithmetic unit that calculates aberration based on a plurality of images obtained under different conditions of the incident angle range.

4. The electron microscope according to any one of claims 1 to 3, wherein the deflector is an electrostatic deflector.

5. An aberration measurement method for an electron microscope, the method comprising:

scanning a specimen with electron beams so that the electron beams have a plurality of irradiation positions on the specimen, and deflecting the electron beams transmitted through each of the irradiation positions, so that a plurality of electron beams which have the same irradiation position and different incident angle ranges with respect to the specimen are caused to sequentially enter the detector; and

calculating aberration based on a plurality of images obtained under different conditions of the incident angle range.

100

10

12

14

EB

16

16

S

20

50

2

30

60

40

# FIG. 1

CONVERGENCE
ANGLE α

AZIMUTH
ANGLE θ

18a

18a    18    OPTICAL AXIS

FOCAL
DISTANCE

α    GEOMETRICAL
ABERRATION

S

EB

CAMERA
LENGTH

DETECTION
SURFACE

FIG. 2

CONVERGENCE ANGLE α

AZIMUTH ANGLE θ

B

A

18a

B   A

S

18

18a

OPTICAL AXIS

FOCAL DISTANCE

α

GEOMETRICAL ABERRATION

S

EB

CAMERA LENGTH

A   B

DETECTION SURFACE

FIG. 3

FIG. 4

FIG. 5

FIG. 6

FIG. 7

FIG. 8

FIG. 9

FIG. 10

FIG. 11

Europäisches
Patentamt

European
Patent Office

Office européen
des brevets

# EUROPEAN SEARCH REPORT

Application Number

**EP 23 16 3038**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2015/015985 A1 (HITACHI HIGH TECH CORP [JP]) 5 February 2015 (2015-02-05) * the whole document * | 1-5 | INV. H01J37/153 H01J37/244 H01J37/28 |
| A | US 2021/082661 A1 (BLOOM RUTH [US] ET AL) 18 March 2021 (2021-03-18) * the whole document * | 4 | |

TECHNICAL FIELDS
SEARCHED      (IPC)

H01J

The present search report has been drawn up for all claims

| Place of search | Date of completion of the search | Examiner |
|---|---|---|
| Munich | 20 July 2023 | Giovanardi, Chiara |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 3038

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2023

| Patent document cited in search report | | Publication date | Patent family member(s) | | Publication date |
|---|---|---|---|---|---|
| WO 2015015985 | A1 | 05-02-2015 | JP | 2015032384 A | 16-02-2015 |
| | | | WO | 2015015985 A1 | 05-02-2015 |
| US 2021082661 | A1 | 18-03-2021 | AU | 2020309555 A1 | 10-02-2022 |
| | | | CA | 3146827 A1 | 14-01-2021 |
| | | | EP | 3997727 A1 | 18-05-2022 |
| | | | JP | 2022540637 A | 16-09-2022 |
| | | | KR | 20220118393 A | 25-08-2022 |
| | | | US | 2021082661 A1 | 18-03-2021 |
| | | | WO | 2021007360 A1 | 14-01-2021 |

EPO FORM P0459

For more details about this annex : see Official Journal of the European Patent Office, No. 12/82

**REFERENCES CITED IN THE DESCRIPTION**

**Patent documents cited in the description**

- JP 2012022971 A